# EUROPEAN PATENT APPLICATION

(11) **EP 4 030 491 A1**
(43) Date of publication of application: **20.07.2022**
(21) Application number: 20863852.8
(22) Date of filing: 14.09.2020
(51) Int. Cl.: H01L 31/0296

(54) **CADMIUM TELLURIDE SOLAR CELL AND PREPARATION METHOD THEREOF**

(30) Priority: 12.09.2019 CN 201910865180
(71) Applicant: China Triumph International Engineering Co., Ltd., Shanghai 200063 (CN)
(72) Inventor: PENG, Shou, Shanghai 200063 (CN); CHEN, Ying, Shanghai 200063 (CN); YIN, Xinjian, Shanghai 20063 (CN); ZHOU, Xianhua, Shanghai 200063 (CN)
(74) Representative: Kailuweit & Uhlemann Patentanwälte Partnerschaft mbB
(86) International application number: PCT/CN2020/115092
(87) International publication number: WO 2021/047673

(57) **Abstract**

The present disclosure provides a cadmium telluride solar cell and a preparation method thereof. The method includes: providing a substrate, and forming a window layer on a first surface of the substrate, wherein the window layer is made of magnesium-doped zinc oxide; forming a light absorbing layer on a surface of the window layer, wherein the light absorbing layer includes a composite layer of cadmium selenide, selenium-doped cadmium telluride, and cadmium telluride; and forming a back electrode layer on a surface of the light absorbing layer. The use of the composite structure of cadmium selenide, selenium-doped cadmium telluride, and cadmium telluride allows the solar cell to absorb long-wavelength and short-wavelength light to the maximum, increases the short-circuit current density of the cell, and improves the efficiency of the cell. In addition, the window layer including magnesium-doped zinc oxide of the solar cell serves as a buffer layer to reduce the recombination of charge carriers between interfaces. Finally, the composite layer of cadmium selenide, selenium-doped cadmium telluride, and cadmium telluride that has a selenium-doped gradient can effectively prevent the diffusion of copper ions to the window layer of magnesium-doped zinc oxide, and reduce the formation of deep-level defects, thereby improving the initial performance and long-term stability of the solar cell.

## Description

### Background of the Present Disclosure

### Field of Disclosure

The present disclosure relates to the field of solar cells, and in particular, to a cadmium telluride solar cell and a preparation method thereof.

### Description of Related Arts

Compared with monocrystalline silicon solar cells, cadmium telluride solar cells have the advantages of convenient fabrication, low costs, and light weight. Cadmium telluride (CdTe) thin-film solar cells, or referred to as CdTe cells for short, are a type of thin-film solar cells based on a heterojunction of p-type CdTe and n-type cadmium sulfide (CdS). Generally, a standard CdTe thin-film solar cell includes five layers: a back electrode, a back contact layer, a CdTe absorbing layer, a CdTe window layer, and a transparent conductive oxide (TCO) layer. The production costs of the CdTe thin-film solar cells are much lower than those of solar cell technologies using crystalline silicon and other materials. In addition, the CdTe thin-film solar cells are very compatible with the solar spectrum, and can absorb 95% or more of sunlight. On the basis of extensive and in-depth application research, CdTe cells have developed from laboratory research to large-scale industrial production. Conventional cadmium telluride processes adopt CdS/CdTe, which has the following disadvantages. First, the use of CdS reduces the absorption of short-wavelength light, reducing the performance of the cell. Second, the CdS used is toxic, which is harmful to the environment and working personnel, and conventionally, chemical bath deposition (CBD) is mostly used for preparing CdS, which produces a lot of waste liquid, and is difficult to control. Third, because a good ohmic contact needs to be formed between the CdTe layer and the back contact layer to achieve high efficiency of solar cells, the interface between the CdTe layer and the back contact layer of the CdTe cell is usually processed by copper diffusion. However, copper will diffuse into the CdS layer through the CdTe layer and form deep-level defects, destroying the p-n junction of CdS/CdTe, resulting in greatly reduced stability of solar cells and continuous degradation of cell performance.

### Summary of the Present Disclosure

In view of the foregoing disadvantages in the related process, an object of the present disclosure is to provide a cadmium telluride solar cell and a preparation method thereof to resolve the problems of low conversion efficiency, low short-circuit current density of a cell, and poor initial performance and long-term stability of a cell in a cell structure of cadmium sulfide/cadmium telluride used in the related art.

In order to accomplish the foregoing object and other related objects, the present disclosure provides a method for preparing a cadmium telluride solar cell, including at least the following steps:
1) providing a substrate layer having a first surface and a second surface opposite to the first surface, and forming a window layer on the first surface of the substrate layer, wherein the window layer is made of magnesium-doped zinc oxide;
2) forming a light absorbing layer on a surface of the window layer away from the substrate layer, wherein the light absorbing layer includes a composite layer of cadmium selenide, selenium-doped cadmium telluride, and cadmium telluride; and
3) forming a back electrode layer on a surface of the light absorbing layer away from the window layer.

Optionally, a method for forming the light absorbing layer in the step 2) includes:
2-1) forming a laminated structure of cadmium selenide and cadmium telluride on the surface of the window layer away from the substrate layer by close space sublimation (CSS); and
2-2) performing activation annealing on the structure obtained in the step 2-1) for the light absorbing layer to form into a composite layer of cadmium selenide, selenium-doped cadmium telluride, and cadmium telluride, the composite layer has a selenium-doped gradient.

Further, a method for forming the laminated structure of cadmium selenide and cadmium telluride in the step 2-1) includes: first forming a cadmium selenide layer on the surface of the window layer away from the substrate layer by CSS; and then forming a cadmium telluride layer on a surface of the cadmium selenide layer by CSS, to form the laminated structure of cadmium selenide and cadmium telluride.

Further, the cadmium selenide layer has a thickness of 100-1700 nm, and the cadmium telluride layer has a thickness of 1300-3900 nm.

Optionally, a method for forming the laminated structure of cadmium selenide and cadmium telluride in the step 2-1) includes: first forming a cadmium selenide layer on the surface of the window layer away from the substrate layer by CSS; then forming a cadmium telluride layer on a surface of the cadmium selenide layer by CSS, to form a laminated substructure of cadmium selenide and cadmium telluride; and repeating the operations of forming a laminated substructure of cadmium selenide and cadmium telluride at least once on the laminated substructure of cadmium selenide and cadmium telluride, to form the laminated structure of cadmium selenide and cadmium telluride.

Further, the cadmium selenide layer has a thickness of 25-450 nm, the cadmium telluride layer has a thickness of 400-1000 nm, and the laminated structure of cadmium selenide and cadmium telluride includes three to six laminated substructures of cadmium selenide and cadmium telluride.

Optionally, in the step 2-2), the activation annealing is carried out at a temperature of 350-600°C for 5-40 min.

Optionally, between the step 2) and the step 3), the method further includes performing copper diffusion on the structure obtained in the step 2) to diffuse copper ions into the surface of the light absorbing layer away from the window layer.

Further, the copper diffusion includes: immersing the structure obtained in the step 2) into a 0.02-0.15 mmol copper chloride solution for 15-180 s, rinsing, and drying.

Optionally, the window layer is formed in the step 1) by magnetron sputtering, the back electrode layer is formed in the step 3) by magnetron sputtering, and the back electrode layer is made of one or more selected from the group consisting of molybdenum, aluminum, and chromium.

Optionally, in the step 1), magnesium is doped in an amount of 0-8 mol% in the magnesium-doped zinc oxide; and in the step 2), selenium is doped in an amount of 3-20 mol% in the light absorbing layer.

The present disclosure further provides a cadmium telluride solar cell, including at least:
a substrate layer, having a first surface and a second surface opposite to the first surface;
a window layer, located on the first surface of the substrate layer, wherein the window layer is made of magnesium-doped zinc oxide;
a light absorbing layer, attached on a surface of the window layer away from the substrate layer, wherein the light absorbing layer includes a composite layer of cadmium selenide, selenium-doped cadmium telluride, and cadmium telluride; and
a back electrode layer, attached on a surface of the light absorbing layer away from the window layer.

Optionally, copper ions are diffused into the surface of the light absorbing layer away from the window layer.

Optionally, the back electrode layer has a thickness of 220-250 nm, the window layer has a thickness of 40-70 nm, the light absorbing layer has a thickness of 2.0-4.0 µm, the substrate layer is made of fluorine-doped tin oxide, conductive glass, titanium oxide, or aluminum-doped zinc oxide, and the back electrode layer is made of one or more selected from the group consisting of molybdenum, aluminum, and chromium.

As described above, the present disclosure provides a method for preparing a cadmium telluride solar cell. In this method, a light absorbing layer is a composite structure of cadmium selenide, selenium-doped cadmium telluride, and cadmium telluride. The composite structure effectively reduces the energy band of cadmium telluride, so that the absorption of light with wavelengths of 700-900 nm by the cell is greatly increased, which allows the solar cell to absorb long-wavelength and short-wavelength light to the maximum, increases the short-circuit current density of the cell, and improves the efficiency of the cell. In addition, a window layer of the solar cell is made of magnesium-doped zinc oxide, and the layer, as a buffer layer in the solar cell, can buffer the contact between a cadmium selenide layer and a substrate layer, to reduce the recombination of charge carriers between interfaces, thereby further increasing the current density. Finally, the composite layer of cadmium selenide, selenium-doped cadmium telluride, and cadmium telluride that has a selenium-doped gradient can effectively prevent the diffusion of copper ions to the window layer of magnesium-doped zinc oxide, and reduce the formation of deep-level defects, thereby improving the initial performance and long-term stability of the solar cell. Moreover, this method has a simple operation and a simple process that is easy to control.

### Brief Description of the Drawings

Fig. 1 is a schematic flowchart of a method for preparing a cadmium telluride solar cell according to the present disclosure.
Figs. 2 to 7 are schematic structural diagrams corresponding to steps in a method for preparing a cadmium telluride solar cell according to the present disclosure.
Fig. 8 is an SEM image of a cross section of a laminated structure of cadmium selenide and cadmium telluride formed by CSS in a method for preparing a cadmium telluride solar cell according to Embodiment 1 of the present disclosure.
Fig. 9 is an SEM image of a cross section of a laminated structure of cadmium selenide and cadmium telluride in Fig. 8 after processed by activation annealing.
Fig. 10 is an SEM image of a cross section of a laminated structure of cadmium selenide and cadmium telluride formed by CSS in a method for preparing a cadmium telluride solar cell according to Embodiment 2 of the present disclosure.
Fig. 11 is an SEM image of a cross section of a laminated structure of cadmium selenide and cadmium telluride in Fig. 10 after processed by activation annealing.

### List of Reference Numerals

- 1: Substrate layer
- 2: Window layer
- 3: Light absorbing layer
- 30: Laminated structure of cadmium selenide and cadmium telluride
- 31: Laminated substructure of cadmium selenide and cadmium telluride
- 32: Cadmium selenide layer
- 33: Cadmium telluride layer
- 4: Back electrode layer
- 5: Copper ion
- S1-S3: Steps

### Detailed Description of the Preferred Embodiments

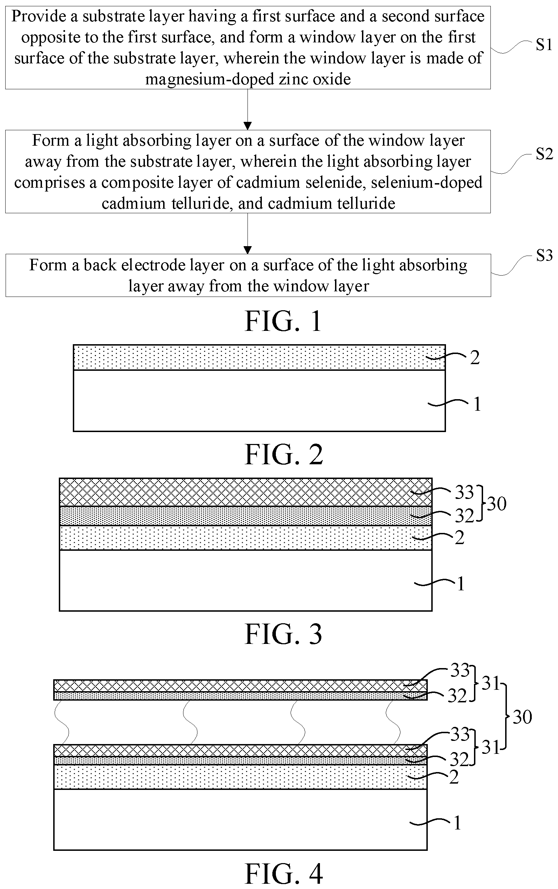

The implementation mode of the present disclosure will be described below through specific embodiments. Those skilled in the art can easily understand other advantages and effects of the present disclosure according to contents disclosed by the specification. The present disclosure can also be implemented or applied through other different specific implementation modes. Various modifications or changes can also be made to all details in the specification based on different points of view and applications without departing from the spirit of the present disclosure. Refer to Figs. 1 to 11. It needs to be stated that the drawings provided in the following embodiments are just used for schematically describing the basic concept of the present disclosure, thus only illustrating components only related to the present disclosure and are not drawn according to the numbers, shapes and sizes of components during actual implementation, the configuration, number and scale of each component during actual implementation thereof may be freely changed, and the component layout configuration thereof may be more complex.

### Embodiment 1

Referring to Fig. 1, the present disclosure provides a method for preparing a cadmium telluride solar cell, the method including the following steps:
S1. Provide a substrate layer having a first surface and a second surface opposite to the first surface, and form a window layer on the first surface of the substrate layer, wherein the window layer is made of magnesium-doped zinc oxide.
S2. Form a light absorbing layer on a surface of the window layer away from the substrate layer, wherein the light absorbing layer includes a composite layer of cadmium selenide, selenium-doped cadmium telluride, and cadmium telluride.
S3. Form a back electrode layer on a surface of the light absorbing layer away from the window layer.

As shown in the step S1 in Fig. 1 and Fig. 2, the step S1 is first carried out. A substrate layer 1 is provided. The substrate layer 1 has a first surface and a second surface opposite to the first surface. A window layer 2 is formed on the first surface of the substrate layer 1. The window layer 2 is made of magnesium-doped zinc oxide.

For example, the substrate layer 1 is made of fluorine-doped tin oxide, conductive glass, titanium oxide, or aluminum-doped zinc oxide, and the substrate layer 1 can be used as a front electrode of the solar cell to conduct electrons and block holes; and a film can be plated on the substrate layer 1 as a substrate to conduct electrons and block holes.

For example, the window layer 2 may be formed by magnetron sputtering, or may be formed by screen printing or radio frequency sputtering; and the window layer 2 has a thickness of 40-70 nm. Preferably, the window layer 2 is made of magnesium-doped zinc oxide with magnesium doped in an amount of 0-8 mol%.

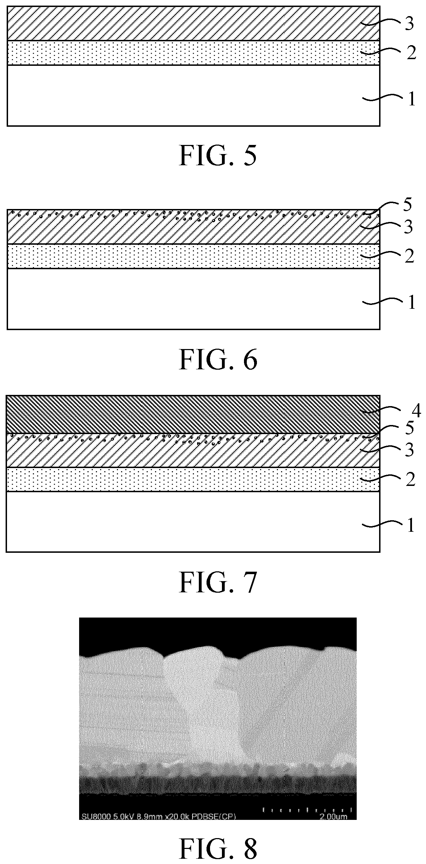

As shown in the step S2 in Fig. 1 and Figs. 3 to 5, the step S2 is then carried out. A light absorbing layer 3 (as shown in Fig. 5) is formed on a surface of the window layer 2 away from the substrate layer 1. The light absorbing layer 3 includes a composite layer of cadmium selenide, selenium-doped cadmium telluride, and cadmium telluride.

In this embodiment, the light absorbing layer 3 is a composite structure of cadmium selenide, selenium-doped cadmium telluride, and cadmium telluride. The composite structure effectively occurs energy offset with the valance band of cadmium telluride, so that the absorption of light with wavelengths of 700-900 nm by the cell is greatly increased, which allows the solar cell to absorb long-wavelength and short-wavelength light to the maximum, increases the short-circuit current density of the cell, and improves the efficiency of the cell. In addition, the window layer 2 of the solar cell is made of magnesium-doped zinc oxide, and the layer, as a buffer layer in the solar cell, can buffer the contact between the cadmium selenide layer and the substrate layer 1, to reduce the recombination of charge carriers between interfaces, thereby further increasing the current density.

For example, selenium is doped in an amount of 3-20 mol% in the light absorbing layer 3.

For example, a method for forming the light absorbing layer 3 includes:
2-1) forming a laminated structure 30 of cadmium selenide and cadmium telluride on the surface of the window layer 2 away from the substrate layer 1 by CSS; and
2-2) performing activation annealing on the structure obtained in the step 2-1) for the light absorbing layer 3 to form into a composite layer of cadmium selenide, selenium-doped cadmium telluride, and cadmium telluride that has a selenium-doped gradient.

Preferably, in the step 2-1), the laminated structure 30 of cadmium selenide and cadmium telluride may be formed at once or in multiple repetitions. Specifically, a method of forming at once is described as follows.

Refer to Fig. 3, a cadmium selenide layer 32 is first formed on the surface of the window layer 2 away from the substrate layer 1 by CSS; and a cadmium telluride layer 33 is then formed on a surface of the cadmium selenide layer 32 by CSS, to form the laminated structure 30 of cadmium selenide and cadmium telluride. Preferably, the cadmium selenide layer 32 has a thickness of 100-1700 nm, and the cadmium telluride layer 33 has a thickness of 1300-3900 nm.

A method of forming in multiple repetitions is described as follows.

Refer to Fig. 4, a cadmium selenide layer 32 is first formed on the surface of the window layer 2 away from the substrate layer 1 by CSS; a cadmium telluride layer 33 is then formed on a surface of the cadmium selenide layer 32 by CSS, to form a laminated substructure 31 of cadmium selenide and cadmium telluride; and the operations of forming a laminated substructure 31 of cadmium selenide and cadmium telluride are repeated at least once on the laminated substructure 31 of cadmium selenide and cadmium telluride, to form the laminated structure 30 of cadmium selenide and cadmium telluride. Preferably, the cadmium selenide layer 32 has a thickness of 25-450 nm, the cadmium telluride layer 33 has a thickness of 400-1000 nm, and the laminated structure 30 of cadmium selenide and cadmium telluride includes three to six laminated substructures 31 of cadmium selenide and cadmium telluride.

For example, in the step 2-2), the activation annealing is carried out at a temperature of 350-600°C for 5-40 min.

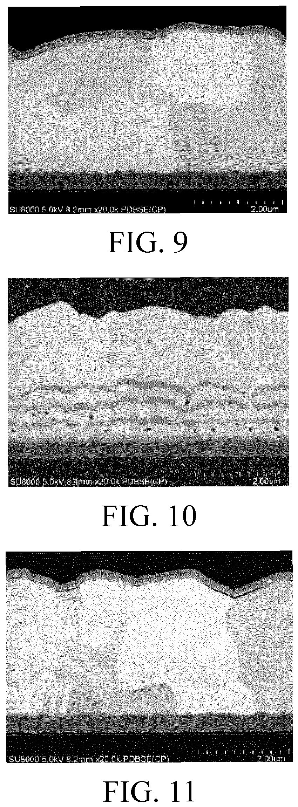

In this embodiment, a composite layer of cadmium selenide, selenium-doped cadmium telluride, and cadmium telluride that has a certain selenium-doped gradient with excellent performance is formed through the deposition of the laminated structure 30 of cadmium selenide and cadmium telluride with activation annealing. This method can achieve the homogenization and controllability of the selenium-doped cadmium telluride layer, thereby further increasing the photocurrent and improving the short-circuit current density of the solar cell. Fig. 8 is an SEM image of a laminated structure 30 of cadmium selenide and cadmium telluride formed at once. Fig. 9 is an SEM image of a laminated structure 30 of cadmium selenide and cadmium telluride in Fig. 8 after processed by activation annealing. Fig. 10 is an SEM image of a laminated structure 30 of cadmium selenide and cadmium telluride formed in multiple repetitions. Fig. 11 is an SEM image of a laminated structure 30 of cadmium selenide and cadmium telluride in Fig. 10 after processed by activation annealing.

For example, referring to Fig. 6, after the light absorbing layer 3 is formed and before the subsequent back electrode layer is formed, copper diffusion needs to be performed on the structure formed in the previous step to diffuse copper ions 5 into the surface of the light absorbing layer 3 away from the window layer 2. Preferably, the copper diffusion includes: immersing the structure obtained in the previous step into a 0.02-0.15 mmol copper chloride solution for 15-180 s, rinsing, and drying.

Generally, cadmium telluride solar cells are processed with copper diffusion to improve the efficiency of the cells. Cadmium sulfide is usually used as a window layer in the related art. During the diffusion, copper ions diffuse into the cadmium sulfide layer due to their characteristics to replace cadmium vacancies, thereby forming deep-level defects and destroying the p-n junction of cadmium sulfide and cadmium telluride, resulting in poor performance of the cell. In this embodiment, the selenium-doped cadmium telluride layer is used. Because selenium is much more soluble in cadmium telluride than sulfur, a composite layer of cadmium selenide, selenium-doped cadmium telluride, and cadmium telluride that has a certain selenium-doped gradient with excellent performance is formed through the deposition of the laminated structure of cadmium selenide and cadmium telluride with activation annealing, which can effectively prevent the diffusion of copper ions to the window layer of magnesium-doped zinc oxide, and reduce the formation of deep-level defects, thereby improving the initial performance and long-term stability of the solar cell.

As shown in the step S3 in Fig. 1 and Fig. 7, the step S3 is then carried out. Aback electrode layer 4 is formed on a surface of the light absorbing layer 3 away from the window layer 2.

For example, the back electrode layer 4 may be formed by, but not limited to, magnetron sputtering, and the back electrode layer 4 is made of one or more selected from the group consisting of molybdenum, aluminum, and chromium.

By using the method for preparing a cadmium telluride solar cell in this embodiment, the highest recorded cell parameters can be obtained by optimizing each parameter, respectively a conversion efficiency of 17.02%, an open-circuit voltage of 823 mV, a short-circuit current density of 27.86 mA/cm², and a fill factor of 74.2%.

### Embodiment 2

The present disclosure further provides a cadmium telluride solar cell structure. The structure may be prepared by the preparation method in Embodiment 1, or may be prepared by other methods. This is not limited herein.

Still referring to Fig. 7, the cadmium telluride solar cell includes at least:
a substrate layer 1, having a first surface and a second surface opposite to the first surface;
a window layer 2, located on the first surface of the substrate layer, wherein the window layer 2 is made of magnesium-doped zinc oxide;
a light absorbing layer 3, located on a surface of the window layer 2 away from the substrate layer 1, wherein the light absorbing layer 3 includes a composite layer of cadmium selenide, selenium-doped cadmium telluride, and cadmium telluride; and
a back electrode layer 4, located on a surface of the light absorbing layer 3 away from the window layer 2.

The light absorbing layer 3 is a composite structure of cadmium selenide, selenium-doped cadmium telluride, and cadmium telluride. The composite structure effectively reduces the energy band of cadmium telluride, so that the absorption of light with wavelengths of 700-900 nm by the cell is greatly increased, which allows the solar cell to absorb long-wavelength and short-wavelength light to the maximum, increases the short-circuit current density of the cell, and improves the efficiency of the cell. In addition, the window layer 2 of the solar cell is made of magnesium-doped zinc oxide, and the layer, as a buffer layer in the solar cell, can buffer the contact between the cadmium selenide layer and the substrate layer 1, to reduce the recombination of charge carriers between interfaces, thereby further increasing the current density.

For example, copper ions 5 are diffused into the surface of the light absorbing layer 3 away from the window layer 2.

Generally, cadmium telluride solar cells are processed with copper diffusion to improve the efficiency of the cells. Cadmium sulfide is usually used as a window layer in the related art. During the diffusion, copper ions diffuse into the cadmium sulfide layer due to their characteristics to replace cadmium vacancies, thereby forming deep-level defects and destroying the p-n junction of cadmium sulfide and cadmium telluride, resulting in poor performance of the cell. In this embodiment, the light absorbing layer is a composite structure of cadmium selenide, selenium-doped cadmium telluride, and cadmium telluride, which can effectively prevent the diffusion of copper ions to the window layer of magnesium-doped zinc oxide, and reduce the formation of deep-level defects, thereby improving the initial performance and long-term stability of the solar cell.

For example, the back electrode layer 4 has a thickness of 220-250 nm, the window layer 2 has a thickness of 40-70 nm, the light absorbing layer 3 has a thickness of 2.0-4.0 µm, the substrate layer 1 is made of fluorine-doped tin oxide, conductive glass, titanium oxide, or aluminum-doped zinc oxide, and the back electrode layer 4 is made of one or more selected from the group consisting of molybdenum, aluminum, and chromium.

As described above, the present disclosure provides a method for preparing a cadmium telluride solar cell. In this method, a light absorbing layer is a composite structure of cadmium selenide, selenium-doped cadmium telluride, and cadmium telluride. The composite structure effectively reduces the energy band of cadmium telluride, so that the absorption of light with wavelengths of 700-900 nm by the cell is greatly increased, which allows the solar cell to absorb long-wavelength and short-wavelength light to the maximum, increases the short-circuit current density of the cell, and improves the efficiency of the cell. In addition, a window layer of the solar cell is made of magnesium-doped zinc oxide, and the layer, as a buffer layer in the solar cell, can buffer the contact between a cadmium selenide layer and a substrate layer, to reduce the recombination of charge carriers between interfaces, thereby further increasing the current density. Finally, the composite layer of cadmium selenide, selenium-doped cadmium telluride, and cadmium telluride that has a selenium-doped gradient can effectively prevent the diffusion of copper ions to the window layer of magnesium-doped zinc oxide, and reduce the formation of deep-level defects, thereby improving the initial performance and long-term stability of the solar cell. Moreover, this method has a simple operation and a simple process that is easy to control. Therefore, the present disclosure effectively overcomes various disadvantages in the related art, and has a high value in industrial use.

The foregoing embodiments merely exemplify the principles and effects of the present disclosure, but are not intended to limit the present disclosure. Any person skilled in the art may make modifications or changes on the foregoing embodiments without departing from the spirit and scope of the present disclosure. Therefore, all equivalent modifications or changes made by a person of ordinary skill in the art without departing from the spirit and technical idea of the present disclosure shall be covered by the claims of the present disclosure.

## Claims

1. A method for preparing a cadmium telluride solar cell, comprising at least the following steps:
1) providing a substrate layer having a first surface and a second surface opposite to the first surface, and forming a window layer on the first surface of the substrate layer, wherein the window layer is made of magnesium-doped zinc oxide;
2) forming a light absorbing layer on a surface of the window layer away from the substrate layer, wherein the light absorbing layer comprises a composite layer of cadmium selenide, selenium-doped cadmium telluride, and cadmium telluride; and
3) forming a back electrode layer on a surface of the light absorbing layer away from the window layer.

2. The method for preparing a cadmium telluride solar cell as in claim 1, wherein a method for forming the light absorbing layer in the step 2) comprises:
2-1) forming a laminated structure of cadmium selenide and cadmium telluride on the surface of the window layer away from the substrate layer by close space sublimation (CSS); and
2-2) performing activation annealing on the structure obtained in the step 2-1) for the light absorbing layer to form into a composite layer of cadmium selenide, selenium-doped cadmium telluride, and cadmium telluride, wherein the composite layer has a selenium-doped gradient.

3. The method for preparing a cadmium telluride solar cell as in claim 2, wherein a method for forming the laminated structure of cadmium selenide and cadmium telluride in the step 2-1) comprises: first forming a cadmium selenide layer on the surface of the window layer away from the substrate layer by CSS; and then forming a cadmium telluride layer on a surface of the cadmium selenide layer by CSS, to form the laminated structure of cadmium selenide and cadmium telluride.

4. The method for preparing a cadmium telluride solar cell as in claim 3, wherein the cadmium selenide layer has a thickness of 100-1700 nm, and the cadmium telluride layer has a thickness of 1300-3900 nm.

5. The method for preparing a cadmium telluride solar cell as in claim 2, wherein a method for forming the laminated structure of cadmium selenide and cadmium telluride in the step 2-1) comprises: first forming a cadmium selenide layer on the surface of the window layer away from the substrate layer by CSS; then forming a cadmium telluride layer on a surface of the cadmium selenide layer by CSS, to form a laminated substructure of cadmium selenide and cadmium telluride; and repeating the operations of forming a laminated substructure of cadmium selenide and cadmium telluride at least once on the laminated substructure of cadmium selenide and cadmium telluride, to form the laminated structure of cadmium selenide and cadmium telluride.

6. The method for preparing a cadmium telluride solar cell as in claim 5, wherein the cadmium selenide layer has a thickness of 25-450 nm, the cadmium telluride layer has a thickness of 400-1000 nm, and the laminated structure of cadmium selenide and cadmium telluride comprises three to six laminated substructures of cadmium selenide and cadmium telluride.

7. The method for preparing a cadmium telluride solar cell as in claim 2, wherein in the step 2-2), the activation annealing is carried out at a temperature of 350-600°C for 5-40 min.

8. The method for preparing a cadmium telluride solar cell as in claim 1, further comprising, between the step 2) and the step 3), a step of performing copper diffusion on the structure obtained in the step 2) to diffuse copper ions into the surface of the light absorbing layer away from the window layer.

9. The method for preparing a cadmium telluride solar cell as in claim 8, wherein the copper diffusion comprises: immersing the structure obtained in the step 2) into a 0.02-0.15 mmol copper chloride solution for 15-180 s, rinsing, and drying.

10. The method for preparing a cadmium telluride solar cell as in claim 1, wherein the window layer is formed in the step 1) by magnetron sputtering, the back electrode layer is formed in the step 3) by magnetron sputtering, and the back electrode layer is made of one or more selected from the group consisting of molybdenum, aluminum, and chromium.

11. The method for preparing a cadmium telluride solar cell as in claim 1, wherein in the step 1), magnesium is doped in an amount of 0-8 mol% in the magnesium-doped zinc oxide; and in the step 2), selenium is doped in an amount of 3-20 mol% in the light absorbing layer.

12. A cadmium telluride solar cell, comprising at least:
a substrate layer, having a first surface and a second surface opposite to the first surface;
a window layer, located on the first surface of the substrate layer, wherein the window layer is made of magnesium-doped zinc oxide;
a light absorbing layer, located on a surface of the window layer away from the substrate layer, wherein the light absorbing layer comprises a composite layer of cadmium selenide, selenium-doped cadmium telluride, and cadmium telluride; and
a back electrode layer, located on a surface of the light absorbing layer away from the window layer.

13. The cadmium telluride solar cell as in claim 11, wherein copper ions are diffused into the surface of the light absorbing layer away from the window layer.

14. The cadmium telluride solar cell as in claim 11, wherein the back electrode layer has a thickness of 220-250 nm, the window layer has a thickness of 40-70 nm, the light absorbing layer has a thickness of 2.0-4.0 µm, the substrate layer is made of fluorine-doped tin oxide, conductive glass, titanium oxide, or aluminum-doped zinc oxide, and the back electrode layer is made of one or more selected from the group consisting of molybdenum, aluminum, and chromium.
